Europäisches Patentamt

European Patent Office

Office européen des brevets

(19)

(11) Veröffentlichungsnummer : **0 167 544 B2**

(12) # NEUE EUROPÄISCHE PATENTSCHRIFT

(45) Veröffentlichungstag der neuen Patentschrift:
23.10.91 Patentblatt 91/43

(51) Int. Cl.$^5$ : **G01R 33/04**

(21) Anmeldenummer : **84904104.1**

(22) Anmeldetag : **14.11.84**

(86) Internationale Anmeldenummer :
**PCT/DE84/00243**

(87) Internationale Veröffentlichungsnummer :
**WO 85/02911 04.07.85 Gazette 85/15**

---

(54) **MAGNETOMETER MIT ZEITVERSCHLÜSSELUNG ZUR MESSUNG VON MAGNETFELDERN.**

(30) Priorität : **17.12.83 DE 3345712**

(43) Veröffentlichungstag der Anmeldung :
**15.01.86 Patentblatt 86/03**

(45) Bekanntmachung des Hinweises auf die
Patenterteilung :
**07.09.88 Patentblatt 88/36**

(45) Bekanntmachung des Hinweises auf die
Entscheidung über den Einspruch :
**23.10.91 Patentblatt 91/43**

(84) Benannte Vertragsstaaten :
**DE FR SE**

(56) Entgegenhaltungen :
**DE-A- 2 949 815**
**DE-C- 3 121 234**
**FR-A- 1 012 220**

(56) Entgegenhaltungen :
**US-A- 3 936 949**
**US-A- 4 290 018**
**US-A- 4 314 200**
**Conference in Precision Electromagnetic Measurements, 1978, Ottawa (CA) W. Heinicke:**
**"Fluxgate-magnetometer using a sensor with direct time-coded output signal", Seiten 89-90,**
**Zeitschrift "messen + prüfen/automatik",**
**Dez. 1972, G. Trenkler: "Verfahren zur elektrischen Messung magnetischer Felder", S. 793-797**

(73) Patentinhaber : **ROBERT BOSCH GMBH**
**Robert-Bosch-Platz 1**
**W-7016 Gerlingen-Schillerhöhe (DE)**

(72) Erfinder : **BAUER, Harald**
**Chamerstrasse 25**
**W-8500 Nürnberg (DE)**
Erfinder : **HETTICH, Gerhard**
**Holzgraben 30**
**W-8501 Rosstal (DE)**

Jouve, 18, rue Saint-Denis, 75001 PARIS

EP 0 167 544 B2

## Beschreibung

### Stand der Technik

Die Erfindung geht aus von einem Magnetometer mit Zeitverschlüsselung zur Messung von Magnetfeldern nach dem Oberbegriff des Patentanspruchs 1 gemäß US-A-3 936 949.

Zur Messung von planetaren Magnetfeldern ist es bereits aus der DE-C-1 623 577 bekannt, Magnetometer mit einer Zeitverschlüsselung zu verwenden. Das Magnetometer enthält eine Sonde mit einem magnetisierbaren stabförmigen Kern, auf dem zwei Wicklungen angeordnet sind. Die eine Wicklung dient zur Erzeugung eines Hilfswechselfeldes, in dem sie an eine Wechselspannung angeschlossen wird, durch die der Kern wechselweise bis in die Sättigung magnetisiert wird. An der anderen Wicklung wird eine Meßspannung abgenommen, die zur Ermittlung des zu messenden Magnetfeldes dient. Dazu wird die Meßspannung mit einem RC-Glied differenziert. Durch das zu messende, in Richtung der Sondenachse wirkende Magnetfeld wird eine zeitliche Verschiebung der Extremwerte der Meßspannung bewirkt, wobei das Maß der Verschiebung ein Maß für die Stärke des gemessenen Magnetfeldes bildet. Über einen Komparator kann die differenzierte Meßspannung in einen der Stärke des Magnetfeldes entsprechenden Digitalwert umgeformt werden. Diese Lösung hat jedoch den Nachteil, daß der magnetisierbare Kern zwei voneinander elektrisch getrennte Wicklungen trägt und die Meßspannung einem Differenzierglied zugeführt werden muß, bevor sie weiter ausgewertet werden kann. Außerdem wird ein eingeschnürter, aufwendig herzustellender Magnetkern verwendet.

Aus der US-A-936 949 ist ein Magnetometer mit einer Auswerteschaltung zur Messung von gleichförmigen Magnetfeldern an Fahrzeugen bekannt, bei dem ein Hilfswechselfeld von einem Rechteckgenerator erzeugt wird, der mit einer Spule auf einem stabförmigen Kern des Magnetometers verbunden ist. Durch das Hilfswechselfeld und das überlagerte, zu messende Gleichfeld wird eine Meßwechselspannung erzeugt, deren positive und negative Halbwellen über Gleichrichter jeweils einem Kondensator zugeführt werden. Je nach Stärke und Richtung des zu messenden Gleichfeldes verschieben sich die Amplitudenwerte der Meßwechselspannung und dementsprechend ändert sich die Ladung der Kondensatoren, die über Entkoppelwiderstände zueinander parallel geschaltet und mit einem Eingang eines Subtrahier-Verstärkers verbunden sind. Das Meßsignal am Ausgang dieses Verstärkers ändert sich damit proportional zum detektierten magnetischen Gleichfeld.

Solche Lösungen haben den Nachteil, daß der stabförmige Kern des Magnetometers zur Vermeidung von Verzerrungen des Meßsignales nur bis an die Sättigungsgrenze heran magnetisiert werden darf, so daß hiermit nur sehr schwache magnetische Gleichfelder und sehr schwache Hilfswechselfelder auftreten dürfen. Ferner ist es nachteilig, daß das zu messende magnetische Gleichfeld dort lediglich die Amplitudenwerte der Meßwechselspannung beeinflußt und daß daraus lediglich ein dem gemessenen magnetischen Gleichfeld proportionales Meßsignal erzeugt wird, das sich ohne weitere Umformerstufen für eine Auswertung durch einen Rechner nicht verwenden läßt. Außerdem wird die Meßgenauigkeit durch die temperaturabhängige Kapazität der Kondensatoren dieser Schaltungsanordnung beeinträchtigt.

Ferner ist es aus einem Bericht der Conference in Precision Electromagnetic Measurements, 1978 Ottawa, Seiten 89 und 90 bekannt, ein Hilfswechselfeld im Kern einer Magnetfeldsonde durch einen Dreieckgenerator zu erzeugen, welches den Kern wechselweise bis in die Sättigung steuert. Dort werden jedoch in zwei zusätzlichen Hilfsspulen des Kernes Meßspannungen erzeugt, deren Amplituden sich abhängig vom angelegten Magnetfeld zeitlich verschieben. Das zeitverschlüsselte Ausgangssignal wird dort durch das Tastverhältnis der Ausgangsspannung eines RS-Flipflops gebildet, das wechselweise durch die gefilterten positiven Spannungsimpulse der beiden Meßspulen umgesteuert wird. Eine solche Lösung ist sehr aufwendig, da sie neben der Hilfsspule für die Vormagnetisierung noch zwei weitere Meßspulen benötigt, deren Meßspannungen außerdem noch über getrennte Impulsformerstufen der eigentlichen Auswerteschaltung zugeführt werden müssen.

Aus der DE-A-29 49 815 ist ein Verfahren zur Messung eines Magnetfeldes bekannt, bei dem auf einem Eisenkern mindestens eine Spule angeordnet ist, an die zur Erregung eine rechteckförmige Wechselspannung bzw. ein Wechselstrom gelegt wird. Zur Bestimmung des Magnetfeldes wird die Impulsdauer der induzierten Spannungsimpulse an der Spule gemessen und mit einem Bezugswert verglichen, der ohne Einwirken eines äußeren Magnetfeldes ermittelt wurde. Aus der Differenz der gemessenen Impulsdauer mit dem Bezugswert wird die Feldstärke des Magnetfeldes bestimmt.

Der Erfindung liegt die Aufgabe zugrunde, mit einem Magnetometer der eingangs genannten Art bei einer Magnetfeldsonde mit nur einer Spule auf möglichst einfache Weise ein digitales Meßsignal zu erhalten, das durch Temperaturschwankungen nicht beeinflußt wird.

Diese Aufgabe ist durch die Merkmale des Patentanspruchs 1 gelöst.

Vorteile der Erfindung

Das erfindungsgemäße Magnetometer hat den Vorteil, daß die Meßspannung der einen Wicklung des magnetisierbaren Kerns unmittelbar an der Auswerteschaltung ein digitales Meßsignal erzeugt, dessen Tastverhältnis durch Größe und Richtung des zu messenden magnetischen Gleichfeldes verändert wird. Eine weitere Vereinfachung und Verbesserung der Meßgenauigkeit ergibt sich bei der vorgeschlagenen Lösung dadurch, daß in der Auswerteschaltung temperaturabhängige Kapazitäten nicht mehr benötigt werden. Vorteilhaft ist ferner die Verwendung eines Dreieckgenerators zur Erzeugung des Hilfswechselfeldes bis jeweils in die Sättigung des magnetisierbaren Kerns, um so eine zeitlich lineare Verschiebung der Sättigungsgrenze abhängig vom zu messenden magnetischen Gleichfeld zu bekommen, die von der Auswerteschaltung für das entsprechend veränderbare Tastverhältnis der abgegebenen Meßspannung verwendet wird.

Durch die in den Unteransprüchen aufgeführten Maßnahmen sind vorteilhafte Weiterbildungen und Verbesserungen der im Patentanspruch 1 angegebenen Merkmale möglich. Dabei ist es besonders zweckmäßig, wenn zur Ermittlung der Stärke des magnetisierten Gleichfeldes nur die in der Wicklung induzierte Spannung verwendet wird. Zu diesem Zweck wird durch einen Subtrahierverstärker die Hilfswechselspannung des Dreieckgenerators in dem Maße von der Meßspannung subtrahiert, daß an seinem Ausgang nur noch eine verstärkte Induktionsspannung erscheint. Dabei ist ein Ausgang des Dreieckgenerators und ein Ende der Wicklung auf ein gemeinsames Bezugspotential, vorzugsweise auf Masse gelegt. Zur Verstärkung der in der Wicklung induzierten Spannung ist das nicht auf Bezugspotential liegende Ende der Wicklung mit dem einen Eingang und der nicht auf Bezugspotential liegende Ausgang des Dreieckgenerators mit dem anderen Ende des Subtrahierverstärkers verbunden.

Zeichnung

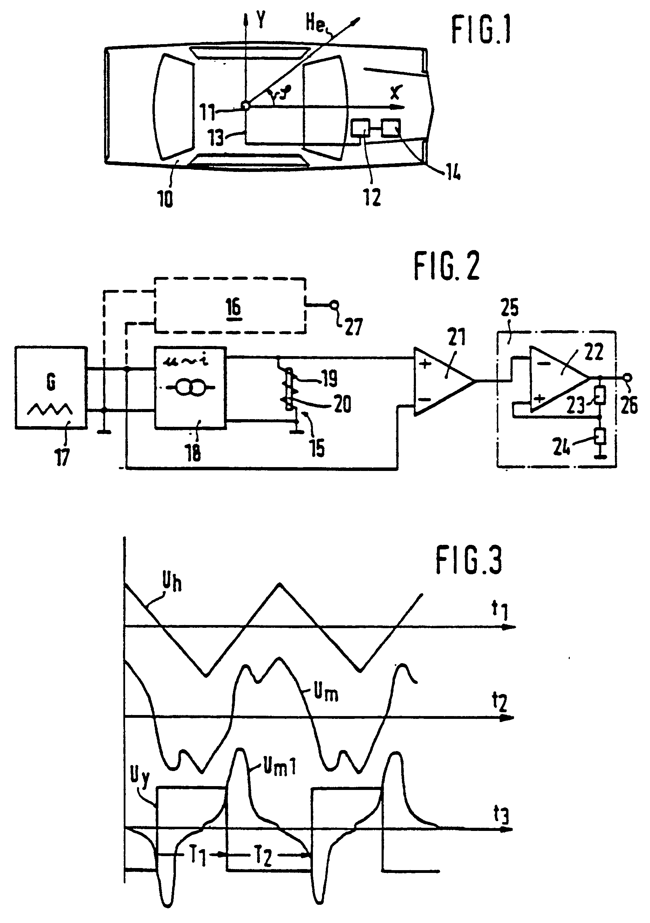

Ein Ausführungsbeispiel der Erfindung ist in der Zeichnung dargestellt und in der nachfolgenden Beschreibung näher erläutert. Es zeigen Figur 1 ein Kraftfahrzeug, bei dem durch einen elektronischen Kompaß mit einem Magnetometer die Fahrrichtung durch Messen des Erdfeldes ermittelt wird, Figur 2 zeigt die Schaltung eines Magnetometers zur Messung einer von einer Sonde erfaßten Magnetfeldkomponente und Figur 3 zeigt den Spannungsverlauf in verschiedenen Punkten der Schaltung nach Figur 2.

Beschreibung des Ausführungsbeispieles

In Figur 1 ist ein Kraftfahrzeug in der Draufsicht dargestellt und mit 10 bezeichnet. Zur Bestimmung der Fahrrichtung ist das Kraftfahrzeug 10 mit einem elektronischen Kompaß ausgerüstet, der aus einem Magnetometer 11 und einer Auswerteschaltung 12 besteht. Das Magnetometer 11 ist unter dem Dach des Kraftfahrzeuges 10 etwa in der Fahrzeugmitte angeordnet und über ein Kabel 13 mit der im Cockpit des Fahrzeuges 10 untergebrachten Auswerteschaltung 12 verbunden. Die mit einem Rechner versehene Auswerteschaltung 12 ist an eine optische Anzeige 14 angeschlossen, die dem Fahrer die augenblickliche Fahrrichtung oder ggf. die einzuschlagende Richtung angibt, um ein zuvor eingegebenes Ziel zu erreichen. Das Magnetometer 11 dient zur Messung der Richtung des Erdfeldes in bezug auf die Längsachse des Kraftfahrzeuges 10. Zu diesem Zweck ist das Magnetometer 11 mit zwei waagerecht angeordneten, um 90° gegeneinander versetzten Sonden ausgerüstet, von denen eine in Figur 2 dargestellt ist. Die eine der beiden Sonden liegt auf der X-Achse und damit in Richtung der Längsachse des Kraftfahrzeuges 10, während die andere Sonde quer dazu in Richtung der Y-Achse liegt. Der Vektor des Erdfeldes He bildet mit der X-Achse einen Winkel φ. Zur Ermittlung dieses Winkels werden in den beiden Sonden des Magnetometers 11 jeweils die X-Komponente bzw. die Y-Komponente des Erdfeldes He gemessen und die entsprechenden Meßwerte werden der Auswerteschaltung 12 zugeführt, in der in an sich bekannter Weise durch den Rechner der Winkel φ berechnet sowie die Fahrrichtung bzw. die Abweichung der Fahrrichtung von der Richtung zum vorgegebenen Ziel ermittelt werden kann.

Figur 2 zeigt den Schaltungsaufbau des Magnetometers 11, wobei der Schaltungszweig mit der in Richtung der Y-Achse liegenden Sonde 15 im einzelnen dargestellt und im folgenden näher erläutert wird. Der in gleicher Weise aufgebaute Schaltungszweig für die in Richtung der X-Achse liegende Sonde ist der Einfachheit halber gestrichelt als Schaltungsblock 16 dargestellt. Beide Schaltungszweige werden von einem Dreiecksgenerator 17 versorgt, an dessen Ausgang eine in Figur 3 dargestellte Hilfswechselspannung Uh mit einer Amplitude von 500 mV und einer Frequenz von f = 1 kHz auftritt. Der Ausgang des Dreieckgenerators 17 ist mit dem Eingang einer spannungsgesteuerten Stromquelle 18 verbunden, wobei ein Anschluß auf Massepotential liegt. Der Ausgang der Stromquelle 18 ist an eine Wicklung 19 angeschlossen, die auf einem hochpermeablen, stabförmigen Kern 20 der Sonde 15 angeordnet ist. Die Wicklung 19 liegt ebenfalls mit einem Ende auf Massepotential. Das andere Ende der Wicklung Ig liegt ferner am Plus-Eingang eines Subtrahierverstärkers 21, dessen Minus-Eingang mit dem nicht auf Masse liegenden Ausgang des Dreieckgenerators 17 verbunden ist. Der Ausgang des Subtrahierverstärkers 21 ist mit dem Eingang eines Schwellwertschalters verbunden, der aus einem Schmitt-Trigger 25 mit zueinander symmetrischen Schaltschwellen besteht. Der Schmitt-Trigger wird aus einem Operationsverstärkers 22 gebildet, dessen Minus-Eingang mit dem Ausgang des Subtrahierverstärkers 21 und dessen PlusEingang mit dem Abgriff eines Spannungsteilers aus den Widerständen 23 und 24 verbunden ist und der zwischen dem Ausgang des Operationsverstärkers 22 und dem Massepotential liegt. Der Schaltungsblock 16 enthält für die in X-Richtung liegende, nicht dargestellte Sonde ebenfalls eine spannungsgesteuerte Stromquelle 18, einen Subtrahierverstärker 21 und einen Schmitt-Trigger 25 in entsprechender Schaltung. Die Ausgäne 26 und 27 der Schaltungsanordnung sind über das Kabel 13 mit der Auswerteschaltung 12, 14 (Figur 1) zu verbinden.

Die Funktionsweise des Magnetometers 11 soll nun mit Hilfe der in Figur 3 dargestellten Spannungsverläufe näher erläutert werden. Die am Ausgang des Dreieckgenerators 17 auftretende Hilfswechselspannung Uh ist auf der Zeitachse t1 aufgetragen. Sie steuert die Stromquelle 18 in der Weise, daß in der an ihrem Ausgang angeschlossenen Wicklung 19 ein entsprechend dreieckförmig verlaufender Hilfwechselstrom auftritt, der in dem magnetisierbaren Kern 20 der Sonde 15 ein Hilfswechselfeld erzeugt. Durch dieses Hilfswechselfeld wird der Kern 20 wechselweise, d. h. in wechselnder Richtung bis in die Sättigung magnetisiert. Da der Kern 20 außerdem von der Y-Komponente des Erdfeldes He (Figur 1) durchsetzt wird, überlagern sich beide Felder im Kern 20. Die Y-Komponente des Erdfeldes He bildet dabei das mit der Sonde 15 zu messende Magnetfeld, das den Kern 20 nur in einer Richtung durchsetzt und dadurch den Kern 20 in einer Magnetisierungsrichtung früher in den Sättigungsbereich bringt, die Sättigung dagegen in der entgegengesetzten Magnetisierungsrichtung verzögert. Das zu messende Magnetfeld und das vom Wechselstrom erzeugte Hilfswechselfeld erzeugen zusammen mit der angelegten, den Magnetisierungsstrom treibenden Spannung an der Wicklung 19 eine Meßspannung Um, die in Figur 3 auf der Zeitachse t2 dargestellt ist. Durch den Subtrahierverstärker 21 wird nun die Hilfswechselspannung Uh des Dreieckgenerators 17 von der Meßspannung Um in dem Maße subtrahiert, daß am Ausgang des Subtrahierverstärkers 21 nunmehr die auf der Zeitachse t3 dargestellte verstärkte Meßspannung Um1 auftritt, die der vom gesamten Magnetfeld in der Wicklung 19 induzierten Spannung entspricht. Die positiven und negativen Halbwollen der Meßspannung Um an der Wicklung 19 bzw. der verstärkten Meßspannung Um1 am Ausgang des Subtrahierverstärkers 21 weichen in Abhängigkeit von dem zu mesisenden Magnetfeld voneinander ab. Die Größe der Abweichung ist dabei ein Maß für die GröBe des gemessenen Magnetfeldes an der Sonde. 15 und folglich ein Maß für die Y-Komponente des Erdfeldes He. Zur Erfassung dieser

Abweichung zwischen der positiven und negativen Halbwellen wird die verstärkte Meßspannung Um1 am Ausgang des Subtrahierverstärkers 21 auf den Eingang des Schmitt-Triggers 25 gelegt. Die dadurch am Ausgang 26 erzeugte rechteckförmige, auf der Zeitachse t3 dargestellte Ausgangsspannung Uy wird der Auswerteschaltung 12 (Figur 1) zugeführt, wobei das Tastverhältnis der Rechteckspannung, d. h. die Zeitdauer T1 der positiven Amplitude zur Zeitdauer T2 der negativen Amplitude ein Maß für die Große der Y-Komponente des Erdfeldes He darstellt. Das Tastverhältnis $T1/(T1 + T2)$ wird dabei von dem Rechner, vorzugsweise ein Mikrocomputer der Auswerteschaltung 12 ermittelt und weiter verarbeitet bzw. gespeichert.

In gleicher Weise wird im Schaltungsblock 16 die X-Komponente des Erdfeldes He ermittelt und über den Ausgang 27 in Form einer pulslängenmodulierten Rechteckspannung mit einem der X-Komponente des Erdfeldes entsprechenden Tast-verhältnis der Auswerteschaltung 12 (Figur 1) zugeführt. Liegt das zu ermittelnde Erdfeld genau in Fahrrichtung, also in Richtung der Y-Achse, so wird nur an einer Sonde das Magnetfeld gemessen. An der anderen Sonde ist die Magnetfeldkomponente gleich Null. Demzufolge wird an dieser Sonde eine Meßspannung mit genau gleichen positiven und negativen Halbwellen erzeugt und demzufolge wird das Tastverhältnis der ihm zugeordneten Ausgangsspannung Uy bzw. Ux gleich 50 %. Zur Realisierung der Schaltung nach Figur 2 können für den Dreieckgenerator 17, die spannungsgesteuerte Stromquelle 18 sowie für den Subtrahierverstärker 21 und den SchmittTrigger 25 bekannte Operationsverstärker verwendet werden, die mit einer stabilisierten Gleichspannung zu versorgen sind.

Im Rahmen der Erfindung ist es auch möglich, für die beiden, um 90° gegeneinander verdrehten Sonden des Magnetometers 11 nur eine spannungsgesteuerte Stromquelle 18 sowie einen Subtrahierverstärker 21 und nur einen SchmittTrigger 25 vorzusehen, wenn der Ausgang der Stromquelle 18 sowie der Plus-Eingang des Sutitrahierverstärkers 21 in festen Zeitabständen jeweils von der einen Sonde 15 auf die andere umgeschaltet wird. Ebenso wäre es denkbar, daß lediglich die Ausgänge der Subtrahierverstärker 21 durch ständiges Umschalten auf einen gemeinsamen Schmitt-Trigger gelegt werden. In beiden Fällen ist nur eine Übertragungsleitung vom Magnetometer 11 zur Auswerteschaltung 12 erforderlich. Im Rahmen der Erfindung ist es aber ebenso möglich, das Magnetometer 11 mit der Auswerteschaltung 12 und dem Anzeigegerät 13 räumlich zu einem elektronischen Kompaß zusammenzufassen. Andererseits ist es auch möglich, lediglich die beiden Sonden an einem geeigneten Ort im Kraftfahrzeug, z.B. unter der Heckscheibe separat von der übrigen Elektronik anzuordnen.

Schließlich kann der elektronische Kompaß auch mit nur einer Sonde 15 betrieben werden. In diesem Fall wird die Richtung des Erdfeldes und damit die Richtung des magnetischen Nordpoles dadurch ermittelt, daß der Sensor 15 mit dem waagerecht angeordneten magnetisierbaren Kern 20 soweit gedreht wird, bis das zu messende Magnetfeld einen maximalen Meßwert abgibt.

Es sei schließlich darauf hingewiesen, daß die Auswerteschaltung Gegenstand der parallelen zeitgleichen Anmeldung WO 85/02912 ist.

## Patentansprüche

1. Magnetometer (11) zur Messung von gleichförmigen Magnetfeldern (He) mit einer Zeitverschlüsselung, bestehend aus mindestens einer Sonde (15) mit einem waagerecht angeordneten, magnetisierbaren, stabförmigen Kern (20) und mit einer darauf angeordneten Wicklung (19), die von einem Wechselstrom einer gesteuerten Wechselstromquelle (18) zur Erzeugung eines Hilfswechselfeldes durchflossen ist, welches den Kern (20) wechselweise magnetisiert und zuammen mit dem zu messenden Magnetfeld in derselben, zugleich mit einer Auswerteschaltung (21, 25, 12, 13) verbundenen Wicklung (19) eine Meßspannung (Um) erzeugt, deren positive und negative Halbwellen in Abhängigkeit von dem zu messenden Magnetfeld voneinander abweichen und zur Bestimmung der Größe des zu messenden Magnetfeldes dienen, dadurch gekennzeichnet,

a) daß zur Erzeugung des Hilfswechselfeldes die Wicklung (19) einerseits an eine von einem Dreieckgenerator (17) gesteuerte Wechselstromquelle (18) und andererseits zur Auswertung der an ihr abgreifbaren Meßspannung (Um) mit nur einem Ende an eine Auswerteschaltung (21, 25, 12, 13) angeschlossen ist,

b) daß ein Ausgang des Dreieckgenerators (17) und das andere Ende der Wicklung (19) auf einem gemeinsamen Bezugspotential liegen,

c) daß zur Auswertung der Meßspannung (Um) das nicht auf Bezugspotential liegende Ende der Wicklung (19) mit dem einen Eingang und der nicht auf Bezugspotential liegende Ausgang des Dreieckgenerators (17) mit dem anderen Eingang eines Subtrahierverstärkers (21) verbunden ist und

d) daß die Wechselstromquelle (18) den Kern (20) der Sonde (15) soweit in die Sättigung steuert, daß das durch das zu messende Magnetfeld (He) veränderbare Tastverhältnis (T1/(T1+T2)) der Meßspannung (Um) in der Auswerteschaltung (21, 25, 12, 13) den zeitverschlüsselten Meßwert für die Größe des an der Sonde (15) wirksammen Magnetfeldes (He) bildet.

## Claims

1. Magnetometer (11) for measuring uniform magnetic fields (He) with a time encryption, consisting of at least one probe (15) with a horizontally arranged, magnetizable, stick-shaped core (20) and with a winding (19) arranged thereupon, through which winding an alternating current of a controlled alternating current source (18) flows for the generation of an auxiliary alternating field, which alternatingly magnetizes the core (20), and together with the magnetic field to be measured in the same winding (19) at the same time connected to an evaluation circuit (21, 25, 12, 13), generates a measurement voltage (Um), the positive and negative half-waves of which deviate from each other as a function of the magnetic field to be measured and serve to determine the size of the magnetic field to be measured, characterized in that

a) to generate the auxiliary alternating field, the winding (19) is connected on the one hand to an alternating current source (18), controlled by a triangular-wave generator (17), and on the other hand, for evaluation of the measurement voltage (Um) which can be tapped from said winding, by only one end to an evaluation circuit (21, 25, 12, 13).

b) an output of the triangular-wave generator (17) and the other end of the winding (19) are at a common reference potential

c) that for evaluation of the measurement voltage (Um), the end of the winding (19) not at reference potential is connected to the one input and the output of the triangular-wave generator (17) not at reference potential is connected to the other input of a substractor amplifier (21).

d) the alternating current source (18) controls the core (20) of the probe (15) into saturation so far that the pulse duty factor (T1/(T1 + T2)) of the measurement voltage (Um) in the evaluation circuit (21, 25, 12, 13), which factor can be varied by the magnetic field (He) to be measured, forms the time-encrypted measured value for the size of the magnetic field (He) effective at the probe (15).

2. Magnetometer according to Claim 1, characterized in that the output of the substractor amplifier (21) is connected to the input of a Schmitt trigger (25), the output (26) of which is connected to a computer of the evaluation circuit (12).

2. Magnetometer nach Anspruch 1, dadurch gekennzeichnet, daß der Ausgang des Subtrahierverstärkers (21) mit dem Eingang eines Schmitt-Triggers (25) verbunden ist, dessen Ausgang (26) mit einem Rechner der Auswerteschaltung (12) verbunden ist.

## Revendications

1. Magnétomètre (11) pour mesurer des champs magnétiques uniformes (He) avec un codage dans le temps, magnétomètre constitué d'au moins une sonde (15) avec un noyau magnétisable (20) en forme de barreau disposé horizontalement, et avec un enroulement (19) disposé sur ce noyau et qui est parcouru par un courant alternatif d'une source de courant alternatif commandée (18) pour produire un champ alternatif auxiliaire, lequel magnétise de façon alternative le noyau (20) et engendre conjointement avec le champ magnétique à mesurer, dans ce même enroulement (19) relié en même temps à un circuit d'exploitation (21, 25, 12, 13), une tension de mesure (Um) dont les demi-ondes positives et négatives se différencient les unes des autres en fonction du champ magnétique à mesurer et servent à déterminer la grandeur de ce champ magnétique à mesurer, magnétomètre caractérisé en ce que :

a) pour produire le champ alternatif auxiliaire, l'enroulement (19) est raccordé, d'une part, à une source de courant alternatif (18) commandée par un générateur de signaux en dents de scie (17), et est raccordé, d'autre part, pour l'exploitation de la tension de mesure (Um) susceptible d'être prélevée sur lui, par seulement une de ses extrémités à un circuit d'exploitation (21, 25, 12, 13),

b) une sortie du générateur (17) de signaux en dents de scie et l'autre extrémité de l'enroulement (19) sont à un même potentiel de référence commun,

c) pour l'exploitation de la tension de mesure (Um), l'extrémité, qui n'est pas au potentiel de référence, de l'enroulement (19) est reliée à l'une des entrées d'un amplificateur-soustracteur (21), tandis qu'à l'autre entrée de celui-ci est reliée la sortie, qui n'est pas au potentiel de référence, du générateur (17) de signaux en dents de scie,

d) la source de courant alternatif (18) commande à la saturation le noyau (20) de la sonde (15) dans une mesure telle que le taux d'impulsion (T1/(T1+T2), susceptible d'être modifié par le champ magnétique (He) à mesurer, de la tension de mesure (Um), forme dans le circuit d'exploitation (21, 25, 12, 13) la valeur de mesure codée dans le temps pour la grandeur du champ magnétique (He) agissant sur la sonde (15).

2. Magnétomètre selon la revendication 1, caractérisé en ce que la sortie de l'amplificateur-soustracteur (21) est reliée à l'entrée d'un déclencheur de Schmitt (25), dont la sortie (26) est reliée à un calculateur du circuit d'exploitation (12).

# FIG.1

# FIG. 2

# FIG.3